# EUROPEAN PATENT APPLICATION

(11) **EP 4 361 308 A1**
(43) Date of publication of application: **01.05.2024**
(21) Application number: 23206040.0
(22) Date of filing: 26.10.2023
(51) Int. Cl.: C23C 14/12, C23C 14/24

(54) **DEPOSITION SOURCE AND DEPOSITION APPARATUS INCLUDING THE SAME**

(30) Priority: 27.10.2022 KR 20220140398
(71) Applicant: Samsung Display Co., Ltd., Yongin-si, Gyeonggi-do 17113 (KR)
(72) Inventor: SEOL, Jaewan, 17113 Yongin-si (KR); YOON, Intaek, 17113 Yongin-si (KR); CHOI, Jonghyun, 17113 Yongin-si (KR)
(74) Representative: Walaski, Jan Filip

(57) **Abstract**

A deposition source includes a nozzle member, a vaporizing member, and a connecting member. The nozzle member includes a body portion including at least one first hole formed in a slot hole, a plurality of nozzles coupled to a first surface of the body portion and that eject a deposition material to an outside, and a crucible including at least one second hole overlapping the first hole and coupled to a second surface of the body portion by a fastening member inserted into the first hole and the second hole. The fastening member includes a bolt, a nut, and a washer. The vaporizing member is spaced apart from the nozzle member and stores the deposition material; and the connecting member connects the nozzle member and the vaporizing member. The deposition material moves through the connecting member.33

## Description

### BACKGROUND

### 1. Technical Field

Embodiments relate to a deposition source used in a deposition process and a deposition apparatus including the deposition source.

### 2. Description of the Related Art

A method of forming a thin film on a substrate includes a physical vapor deposition ("PVD") method such as a vacuum evaporation method, an ion plating method, or a sputtering method, and a chemical vapor deposition ("CVD") method by using gas reaction.

A deposition apparatus for performing the vacuum evaporation method has a crucible for storing an evaporation material, a heater for heating the crucible, and a deposition source including a nozzle through which the evaporated material is discharged.

An evaporation source (e.g., a linear evaporation source), which is used in the vacuum evaporation method, has a shape elongated in a direction. The linear deposition source may be usefully used to form a deposition film on a large-area substrate.

### SUMMARY

Embodiments provide a deposition source having a shape elongated in a direction.

Embodiments provide a deposition apparatus including the deposition source.

However, embodiments of the disclosure are not limited to those set forth herein. The above and other embodiments will become more apparent to one of ordinary skill in the art to which the disclosure pertains by referencing the detailed description of the disclosure given below.

A deposition source according to embodiments may include a nozzle member including a body portion including at least one first hole formed in a slot hole; a plurality of nozzles coupled to a first surface of the body portion and that eject a deposition material to an outside; and a crucible including at least one second hole overlapping the first hole and coupled to a second surface of the body portion by a fastening member inserted into the first hole and the second hole, the fastening member including a bolt, a nut, and a washer; a vaporizing member spaced apart from the nozzle member and storing the deposition material, and a connecting member connecting the nozzle member and the vaporizing member, the connecting member through which the deposition material moves.

In an embodiment, each of the plurality of nozzles may extend in a first direction and the plurality of nozzles may be spaced apart from each other along a second direction perpendicular to the first direction.

In an embodiment, a diameter of the first hole in the second direction may be greater than a diameter of the second hole in the second direction.

In an embodiment, each of the plurality of nozzles may be configured to spray the deposition material in the first direction and each of the body portion and the crucible may extend in the second direction.

In an embodiment, the deposition source may further include an insulating member adjacent to the plurality of nozzles and coupled to a plurality of plates.

In an embodiment, the plurality of plates may be coupled by a first fastening member penetrating the plurality of plates and a second fastening member disposed between the plurality of plates and surrounding the first fastening member.

In an embodiment, the first fastening member may have a pin shape, and the second fastening member may have a ring shape.

In an embodiment, the deposition source may further include a heating member adjacent to the vaporizing member and heating the vaporizing member.

In an embodiment, the heating member may surround at least a portion of the vaporizing member.

In an embodiment, the heating member may include a first heating member adjacent to a side surface of the vaporizing member and a second heating member adjacent to an upper surface of the vaporizing member.

In an embodiment, the body portion and the plurality of nozzles may be integral with each other.

In an embodiment, the body portion and the plurality of nozzles may be formed independently of each other.

In an embodiment, each of the nozzle member and the vaporizing member may include a heat-resistant material.

In an embodiment, the deposition material may include a metal or an inorganic insulating material.

A deposition source according to embodiments may include a nozzle member including a body portion, a plurality of nozzles coupled to a first surface of the body portion and that eject a deposition material to an outside, and a crucible coupled to a second surface of the body portion, a block member surrounding at least a portion of a side surface of each of the body portion and the crucible, a vaporizing member spaced apart from the nozzle member and storing the deposition material, and a connecting member connecting the nozzle member and the vaporizing member, the connecting member through which the deposition material moves.

In an embodiment, the block member may include an upper block contacting at least a portion of the side surface of the body portion and a lower block contacting at least a portion of the side surface of the crucible.

In an embodiment, each of the upper block and the lower block may include a coupling groove penetrating the upper block and the lower block, and the upper block and the lower block may be coupled by a fastening member inserted into the coupling groove.

In an embodiment, the fastening member may include a bolt and a nut.

In an embodiment, the upper block and the lower block may have symmetrical shapes.

In an embodiment, the deposition source may further include an insulating member adjacent to the plurality of nozzles.

In an embodiment, the insulating member may include a first plate and a second plate disposed on the first plate.

In an embodiment, the insulating member may include a plurality of plates coupled to each other.

In an embodiment, the plurality of plates may be coupled by a first fastening member penetrating the plurality of plates and a second fastening member disposed between the plurality of plates and surrounding the first fastening member.

In an embodiment, the first fastening member may have a pin shape, and the second fastening member may have a ring shape.

A deposition apparatus according to embodiments may include a substrate holder disposed in a process chamber and fixing a substrate and a deposition source facing the substrate holder. The deposition source may include a nozzle member including: a body portion including at least one first hole formed in a slot hole; a plurality of nozzles coupled to a first surface of the body portion and that eject a deposition material to an outside; and a crucible including at least one second hole overlapping the first hole and coupled to a second surface of the body portion by a fastening member inserted into the first hole and the second hole, the fastening member including a bolt, a nut, and a washer; a vaporizing member spaced apart from the nozzle member and storing the deposition material, and a connecting member connecting the nozzle member and the vaporizing member, the connecting member through which the deposition material moves.

In a deposition source and a deposition apparatus including the deposition source according to an embodiment, the deposition source may include a nozzle member, a vaporizing member spaced apart from the nozzle member, and a connecting member connecting the nozzle member and the vaporizing member. The nozzle member may include a body portion including at least one first hole formed in a slot hole, a plurality of nozzles coupled to a first surface of the body portion and that eject a deposition material to an outside, and a crucible including at least one second hole overlapping the first hole and coupled to a second surface of the body portion by a fastening member inserted into the first hole and the second hole, the fastening member including a bolt, a nut, and a washer. Accordingly, since the body portion and the crucible may slide by the difference in thermal expansion amounts between the body portion and the crucible, deformation of the fastening member due to the difference in thermal expansion amounts between the body portion and the crucible may be prevented. Further, leakage of material through gap in the fastening member may be prevented.

In a deposition source and a deposition apparatus including the deposition source according to another embodiment, a nozzle member including a body portion, a plurality of nozzles coupled to a surface of the body portion, and a crucible coupled to a second surface of the body portion, a block member surrounding at least a portion of a side surface of each of the body portion and the crucible, a vaporizing member spaced apart from the nozzle member, and a connecting member connecting the nozzle member and the vaporizing member, the connecting member through which the deposition material moves. Accordingly, since the body portion and the crucible may slide, leakage of material into the gap between the body portion and the crucible may be prevented.

### BRIEF DESCRIPTION OF THE DRAWINGS

Illustrative, non-limiting embodiments will be more clearly understood from the following detailed description in conjunction with the accompanying drawings.
FIG. 1 is a schematic cross-sectional view of a deposition apparatus according to an embodiment.
FIG. 2 is a schematic perspective view illustrating a nozzle member of FIG.1.
FIG. 3 is a schematic side view illustrating a nozzle module of the nozzle member of FIG. 2.
FIG. 4 is an enlarged schematic perspective view of a portion of the nozzle module of FIG. 3.
FIG. 5 is a schematic cross-sectional view of the nozzle member of FIG. 2 taken along line I-I'.
FIG. 6 is an enlarged cross-sectional view of area A of FIG. 5.
FIG. 7 is a schematic cross-sectional view illustrating a portion of a nozzle member of a deposition source according to an embodiment.
FIG. 8 is a schematic cross-sectional view illustrating a portion of a nozzle member of a deposition source according to an embodiment.
FIG. 9 is an enlarged schematic cross-sectional view of an example of a vaporizing member and a heating member of FIG. 1.
FIG. 10 is an enlarged schematic cross-sectional view of another example of a vaporizing member and a heating member of FIG. 1.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the X, Y, and Z - axes, and may be interpreted in a broader sense. For example, the D1-axis, the D2-axis, and the D3-axis may be perpendicular to one another, or may represent different directions that are not perpendicular to one another. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, *"*at least one of X, Y, and Z*"* and *"*at least one selected from the group consisting of X, Y, and Z*"* may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, a deposition source and a deposition apparatus including the same according to embodiments will be explained in detail with reference to the accompanying drawings. The same reference numerals are used for the same components in the drawings, and redundant descriptions of the same components will be omitted for descriptive convenience.

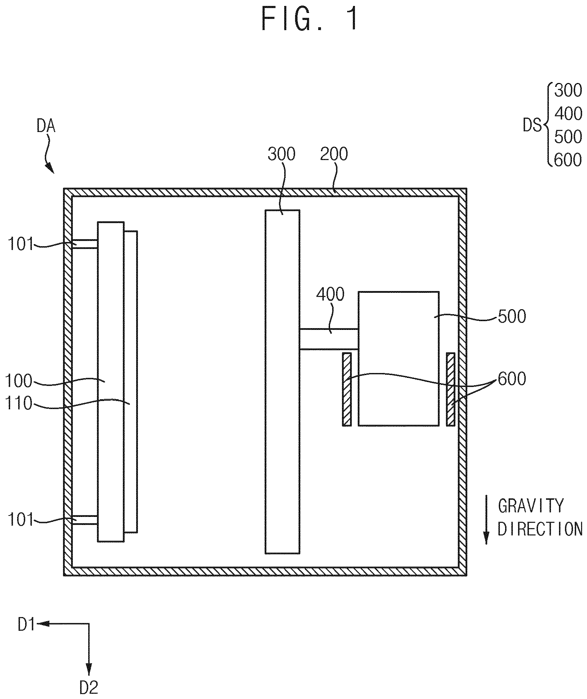

FIG. 1 is a schematic cross-sectional view of a deposition apparatus according to an embodiment.

Referring to FIG. 1, a deposition apparatus DA may include a process chamber 200, a deposition source DS, and a substrate holder 100. For example, the deposition source DS may include a nozzle member 300, a connecting member 400, a vaporizing member 500, and a heating member 600.

The process chamber 200 may provide a space for performing a deposition process. For example, the process chamber 200 may be connected to a vacuum pump for controlling the inner pressure of the process chamber 200 and for exhausting a deposition material not deposited on a substrate 110. The process chamber 200 may have a rectangular parallelepiped shape. For example, the process chamber 200 may include a conductive material.

The deposition source DS may be disposed on a side of the process chamber 200, and the substrate holder 100 may be disposed on another side of the process chamber 200. For example, the deposition source DS may have a shape extending along a direction. The deposition source DS may have a shape extending along a direction of gravity. The deposition source 700 may store a deposition material, may heat the deposition material, and may spray the deposition material onto the substrate 110 to form a film on the substrate 110.

As described above, the substrate holder 100 may be disposed on another side of the process chamber 200. For example, the substrate holder 100 may be disposed inside the process chamber 200. The substrate holder 100 may perform a function of seating the substrate 110 carried into the process chamber 200. The substrate holder 100 may be fixed to the process chamber 200 by a fixing member 101. For example, the substrate holder 100 may extend in a second direction D2 perpendicular to the first direction D1.

The nozzle member 300 may be connected to the vaporizing member 500. For example, the nozzle member 300 may be connected to the vaporizing member 500 through the connecting member 400. For example, the vaporizing member 500 may be disposed to be spaced apart from the nozzle member 300. For example, the deposition source DS may have a form in which the nozzle member 300 and the vaporizing member 500 are separated. The vaporizing member 500 may store deposition materials therein. A detailed description of the nozzle member 300 and the vaporizing member 500 will be described below.

The connecting member 400 may connect the nozzle member 300 and the vaporizing member 500 to provide a space in which the deposition material stored in the vaporizing member 500 moves to the nozzle member 300. The connecting member 400 may extend in the first direction D1. The connecting member 400 may include a heat-resistant material. For example, the connecting member 400 may include a heat-resistant material such as metal, alloy, ceramic, glass, and the like. These may be used alone or in combination with each other. However, embodiments are not limited thereto, and the connecting member 400 may include various heat-resistant materials.

The heating member 600 may be disposed to be adjacent to the vaporizing member 500. The heating member 600 may heat the vaporizing member 500. For example, the heating member 600 may vaporize the deposition material stored in the vaporizing member 500 by heating the vaporizing member 500. The vaporized deposition material may move to the nozzle member 300 through the connecting member 400, and the nozzle member 300 may spray the vaporized deposition material onto the substrate 110.

The deposition material may be a material that is vaporized by heat. For example, the deposition material may include a metal material or an inorganic insulating material. The metal material may include a metal, an alloy, a metal nitride, a conductive metal oxide, a transparent conductive material, and the like. For example, the inorganic insulating material may include silicon oxide, silicon nitride, and the like. Each of these may be used individually or in combination with each other.

In the description, the second direction D2 may be a gravity direction. For example, the first direction D1 may be horizontal to an upper surface of the process chamber 200 and the second direction D2 may be perpendicular to the upper surface of the process chamber 200.

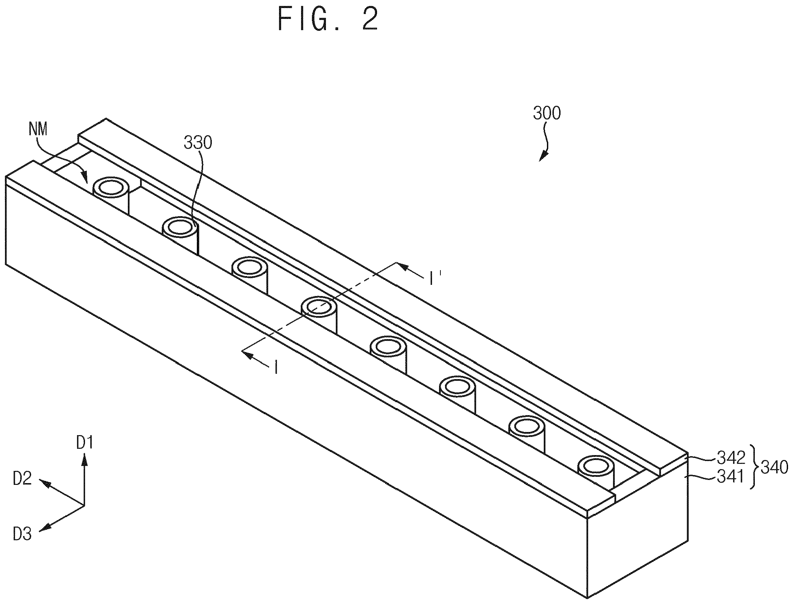

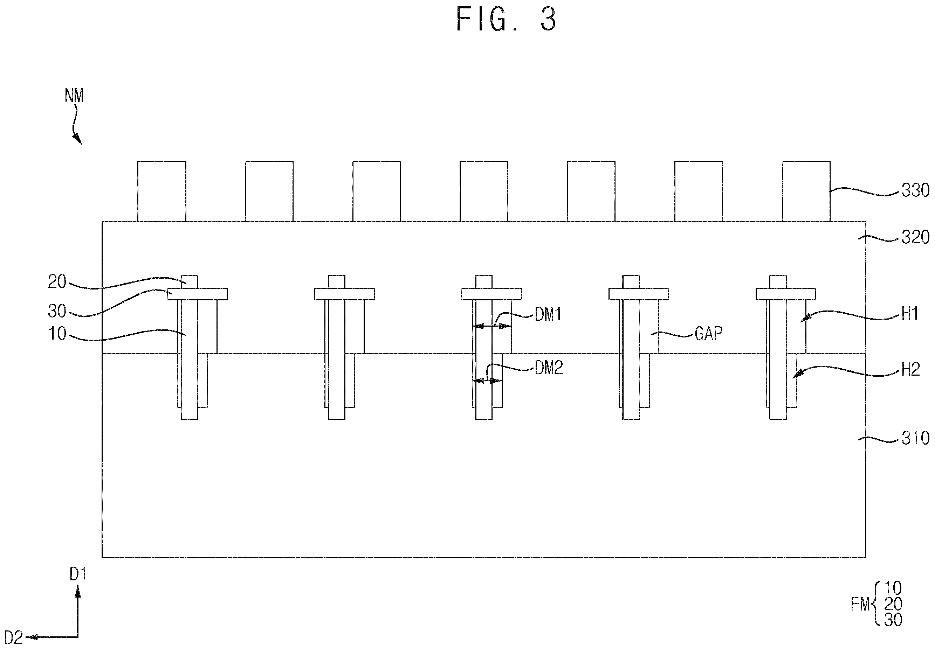

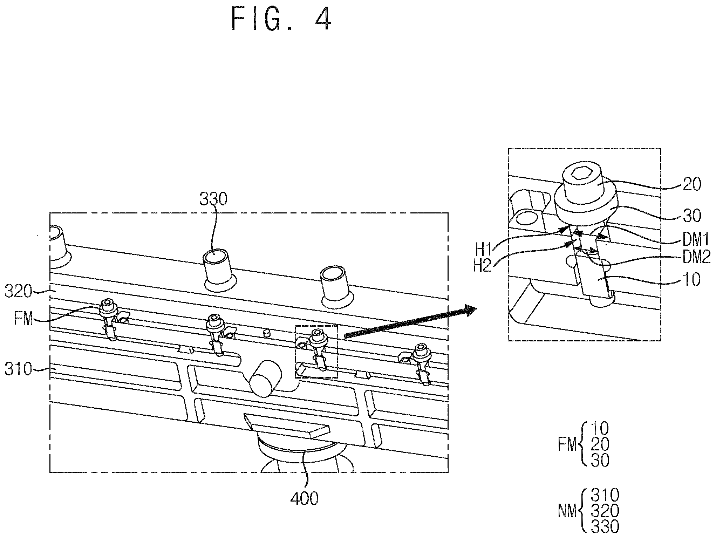

FIG. 2 is a schematic perspective view illustrating a nozzle member of FIG.1. FIG. 3 is a schematic side view illustrating a nozzle module of the nozzle member of FIG. 2. FIG. 4 is an enlarged schematic perspective view of a portion of the nozzle module of FIG. 3.

Referring to FIGS. 1, 2, 3, and 4, the nozzle member 300 of the deposition source DS according to an embodiment may include a nozzle module NM and a housing 340. For example, the nozzle module NM may include a crucible 310, a body (or body portion) 320, and nozzles 330.

The nozzle module NM may provide the deposition material. The nozzle module NM may be accommodated inside the housing 340.

The housing 340 may form an external shape of the nozzle module NM. The housing 340 may extend in a direction. For example, the housing 340 may extend in the second direction D2.

The housing 340 may include a main body 341 having an empty space therein. The main body 341 may accommodate the nozzle module NM in the empty space therein. Therefore, as the main body 341 accommodates the nozzle module NM, the nozzle module NM may be protected. The main body 341 may expose the nozzles 330 in an upward direction (e.g., in the first direction D1).

The housing 340 may further include a plate 342 disposed on the main body 341 and covering a partial area of an exposed upper portion of the main body 341. For example, the plate 342 may be spaced apart at certain intervals along a third direction D3 perpendicular to the first and second directions D1 and D2, respectively to expose the nozzles 330. However, embodiments are not limited thereto. For example, the plate 342 may be integrally formed (or integral) with the main body 341 to cover the entire upper portion of the main body 341, and may have a shape in which openings overlapping the nozzles 330 are defined. In another example, the plate 342 may be omitted.

The nozzles 330 may be coupled to the body (or body portion) 320. For example, the nozzles 330 may be coupled to a first surface of the body 320. Each of the nozzles 330 may extend in the first direction D1. For example, each of the nozzles 330 may protrude from the body 320. Accordingly, each of the nozzles 330 may spray the deposition material in the first direction D1. Each of the nozzles 330 may include a heat-resistant material. For example, each of the nozzles 330 may include a heat-resistant material such as metal, alloy, ceramic, glass, and the like. These may be used alone or in combination with each other.

The nozzles 330 may be disposed to be spaced apart from each other along the second direction D2. For example, the nozzles 330 may be disposed to be spaced apart from each other along the gravity direction. For example, the nozzles 330 may be arranged at substantially equal intervals (or distances) along the second direction D2. In another example, the nozzles 330 may be disposed at non-uniform intervals (or distances) along the second direction D2. For example, intervals (or distances) between the nozzles 330 may be adjusted so that a film formed on the substrate 110 by deposition may have a uniform thickness. The deposition material stored inside the body 320 may be sprayed to the outside through the nozzles 330 and deposited on the substrate 110.

Although the number of the nozzles 330 is eight in FIG. 2, embodiments are not limited thereto. For example, the number of the nozzles 330 may vary.

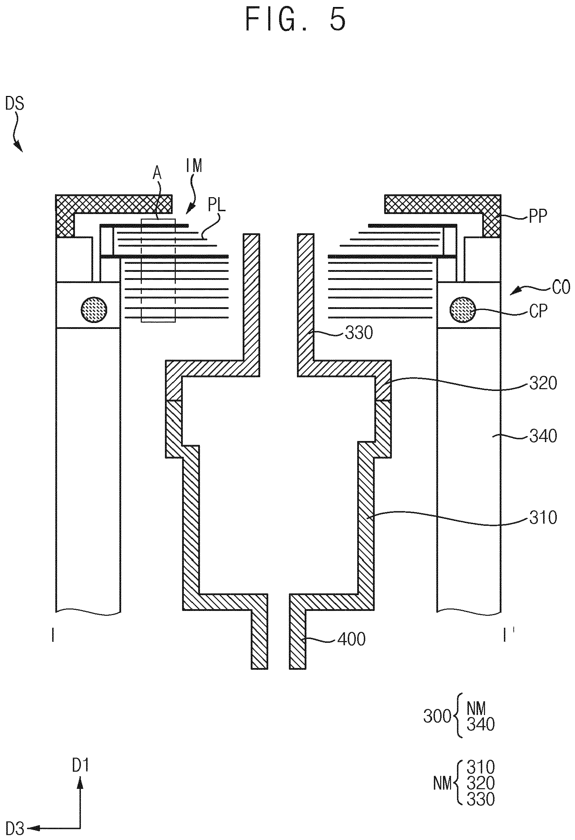

The body 320 may have an empty space therein (see FIG. 5). The body 320 may extend in the second direction D2. For example, the body 320 may have a rectangular shape when viewed from the side. However, embodiments are not limited thereto, and the body 320 may have a different shape when viewed from the side. The body 320 may include a heat-resistant material. For example, the body 320 may include a heat-resistant material such as metal, alloy, ceramic, glass, and the like. These may be used alone or in combination with each other.

The nozzles 330 may be integrally formed (or integral) with the body 320. In another example, the nozzles 330 may be formed independently of (or separately from) the body 320 and then connected to each other.

The nozzles 330 and the body 320 may include the same material. In another example, the nozzles 330 may include a material different from a material of the body 320.

The crucible 310 may be coupled to the body 320. For example, the upper surface of the crucible 310 may contact the lower surface of the body 320. For example, the crucible 310 may be coupled to a second surface of the body 320 facing the first surface. The crucible 310 may have an empty space therein (see FIG. 5). The crucible 310 may extend in the second direction D2. The crucible 310 may include a heat-resistant material. For example, the crucible 310 may include a heat-resistant material such as metal, alloy, ceramic, glass, and the like. These may be used alone or in combination with each other.

The crucible 310 may be coupled to the body 320 through the fastening member FM. For example, at least one first hole H1 may be formed in the body 320 and at least one second hole H2 may be formed in the crucible 310. The second hole H2 may correspond to (or overlap) the first hole H1. The first hole H1 may be formed in the form of a slot. For example, the first hole H1 may be formed as an elongated hole having a long diameter (width) and a short diameter (width). For example, the first hole H1 may have a shape including two arcs connected by straight lines. For example, a diameter (e.g., long diameter) DM1 of the first hole H1 in the second direction D2 may be greater than a diameter DM2 of the second hole H2 in the second direction D2.

The fastening member FM may be inserted into the first hole H1 and the second hole H2 to fasten (or fix) the crucible 310 and the body 320. The fastening member FM may have a form in which a bolt 10, a nut 20, and a washer 30 are fastened. For example, the washer 30 may be positioned between the bolt 10 and the nut 20. The fastening member FM may have a form in which the bolt 10 and the nut 20 are fastened without the washer 30.

The fastening member FM may include a heat-resistant material. For example, the fastening member FM may include a heat-resistant material such as metal, alloy, ceramic, glass, and the like. These may be used alone or in combination with each other.

A temperature difference may occur inside the deposition source DS due to the heating member 600 in FIG. 1. For example, the temperature of the nozzles 330 and the body 320 may be relatively low, and the temperature of the crucible 310 may be relatively high. Due to the temperature difference, the amount of thermal expansion of the crucible 310 may be higher than the amount of thermal expansion of the nozzles 330 and the body 320. Accordingly, deformation of the fastening member FM may occur, and fastening force between the body 320 and the crucible 310 may be weakened. Thus, material leakage may occur through gap in the fastening member FM.

As described above, in case that the first hole H1 is formed as a slot hole and the fastening member FM has a form in which the bolt 10, the nut 20, and the washer 30 are fastened, the body 320 and the crucible 310 may slide (or move) on/from each other by a difference in amount of thermal expansion between the body 320 and the crucible 310. For example, in case that the first hole H1 is formed as a slot (elongate hole), a gap GAP may be formed between (a side of) the first hole H1 and (a side of) the bolt 10 such that the body 320 and the crucible 310 may slide (or move) from each other due to the gap GAP between the first hole H1 and the bolt 10. Accordingly, deformation of the fastening member FM due to a difference in amount of thermal expansion between the body 320 and the crucible 310 may be prevented. For example, to prevent leakage of material through the gap of the fastening member FM may be possible.

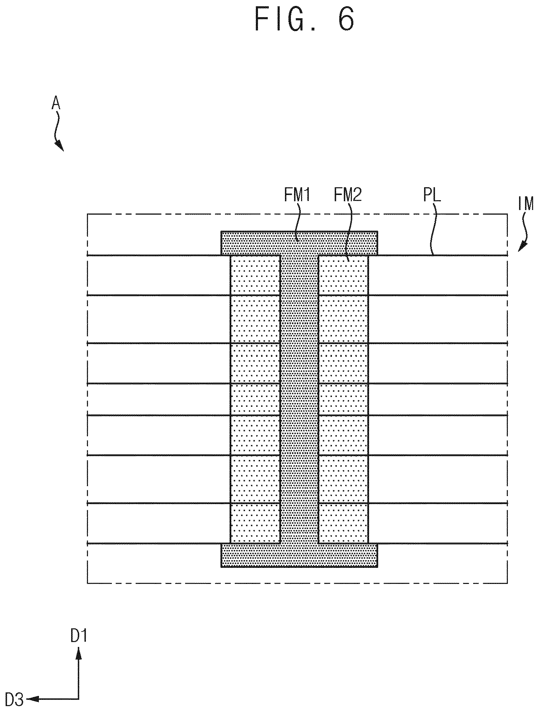

FIG. 5 is a schematic cross-sectional view of the nozzle member of FIG. 2 taken along line I-I'. FIG. 6 is an enlarged schematic cross-sectional view of area A of FIG. 5.

Referring to FIGS. 1, 2, 5, and 6, the nozzle member 300 of the deposition source DS may include the nozzle module NM and the housing 340. For example, the nozzle module NM may include the crucible 310, the body 320, and the nozzles 330.

The deposition source DS may further include a cooling portion CO. The cooling portion CO may be disposed on the housing 340. For example, the cooling portion CO may contact the upper surface of the main body 341 of the housing 340 in FIG. 2. The cooling portion CO may be disposed to surround the upper portion of the main body 341 opened along the upper surface of the main body 341. For example, the plate 342 of the housing 340 may be omitted. The cooling portion CO may cool heat transferred from the heating member 600 to the outside of the deposition source DS. For example, the cooling portion CO may reduce the amount of heat transferred to the substrate 110.

The cooling portion CO may include a cooling pipe CP and a cooling bracket covering an outer surface of the cooling pipe CP. A refrigerant or cooling water may be circulated (or flow) in the cooling pipe CP.

The deposition source DS may further include an anti-deposition plate PP disposed on the cooling portion CO. For example, the anti-deposition plate PP may be disposed to surround the upper surface of the cooling portion CO. For example, an opening overlapping the nozzles 330 may be formed in the anti-deposition plate PP. The anti-deposition plate PP may allow (or guide) the deposition material to be sprayed from the nozzles 330 at a certain angle with respect to the substrate 110. For example, the anti-deposition plate PP may perform a heat insulation function that heat inside the deposition source DS is prevented from leaking to the outside. In another example, the anti-deposition plate PP may be omitted.

The anti-deposition plate PP may include a heat-resistant material. For example, the anti-deposition plate PP may include a heat-resistant material such as metal, alloy, ceramic, glass, and the like. These may be used alone or in combination with each other.

The deposition source DS may further include an insulating member (e.g., heat insulating member) IM. The insulating member IM may prevent heat inside the deposition source DS from leaking to the outside. The insulating member IM may be disposed to be adjacent to the nozzles 330. The heat insulating member IM may include plates PL. For example, the heat insulating member IM may have a multi-stage shape. The plates PL may be coupled to each other. For example, each of the plates PL may extend along a direction (e.g., the second direction D2) in which the nozzles 330 are spaced apart.

As the heat insulating member IM includes the plates PL coupled to each other, a temperature difference between the body 320 and the crucible 310 may be reduced. For example, as the heat insulating member IM includes the plates PL coupled to each other, as the temperature of the anti-deposition plate PP is lowered, heat of the deposition source DS toward the substrate 110 may be reduced.

As illustrated in FIG. 6, the plates PL may be coupled to each other by a first fastening member FM1 and a second fastening member FM2. The first fastening member FM1 may penetrate the plates PL. The second fastening member FM2 may be positioned between the plates PL and may surround the first fastening member FM1. For example, the first fastening member FM1 may have a pin shape, and the second fastening member FM2 may have a ring shape. However, embodiments are not limited thereto.

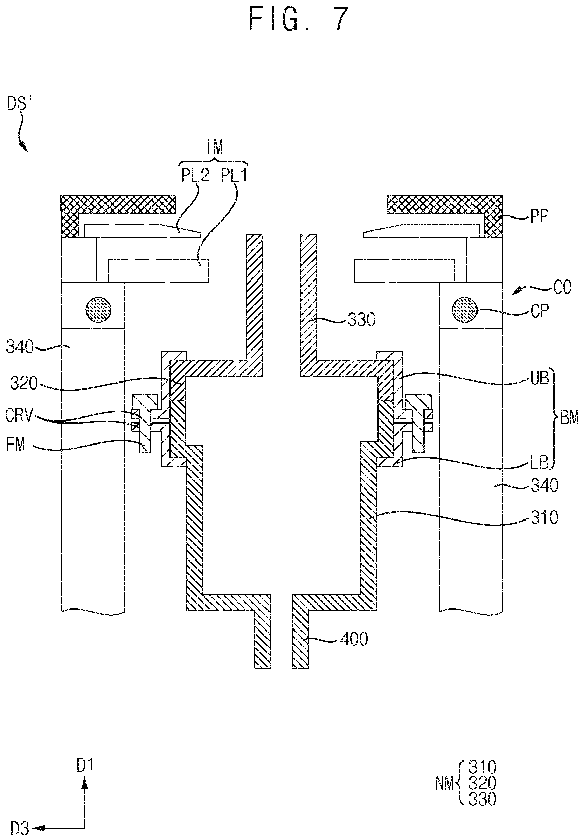

FIG. 7 is a schematic cross-sectional view illustrating a portion of a nozzle member of a deposition source according to an embodiment.

Referring to FIGS. 2 and 7, the nozzle member 300 of the deposition source DS' according to an embodiment may include a nozzle module NM and a housing 340. For example, the nozzle module NM may include a crucible 310, a body 320, and nozzles 330. Hereinafter, redundant descriptions, which are similar to (or same as) the descriptions of the deposition source DS with reference to FIG. 6 will be omitted or simplified for descriptive convenience.

The deposition source DS' further includes a block member BM coupling the body 320 and the crucible 310 together. The block member BM may cover at least a portion of side surface of each of the body 320 and the crucible 310. For example, no hole may be formed in each of the body 320 and the crucible 310. Accordingly, a fastening member (e.g., the fastening member FM of FIGS. 3 and 4) is not required to couple the body 320 and the crucible 310 together.

The block member BM may include an upper block UB and a lower block LB. The upper block UB may contact at least a portion of a side surface of the body 320, and the lower block LB may contact at least a portion of a side surface of the crucible 310. Each of the upper block UB and the lower block LB may extend in the second direction D2. For example, the upper block UB and the lower block LB may have symmetrical shapes.

The upper block UB and the lower block LB may be coupled through a fastening member FM*'*. For example, a coupling groove CRV penetrating the upper block UB and the lower block LB may be formed in each of the upper block UB and the lower block LB, and the fastening member FM' may be inserted into the coupling groove CRV to couple the upper block UB and the lower block LB. For example, the fastening member FM' may be in the form of a fastened bolt and nut. However, embodiments are not limited thereto.

As the deposition source DS' includes the block member BM coupling the body 320 and the crucible 310, the body 320 and the crucible 310 may slide. Accordingly, leakage of material into the gap between the body 320 and the crucible 310 may be prevented.

The deposition source DS' may further include an insulating member (e.g., heat insulating member) IM. The insulating member IM may be disposed to be adjacent to the nozzles 330. For example, the heat insulating member IM may include a first plate PL1 and a second plate PL2 disposed on the first plate PL1. For example, the heat insulating member IM may have a two-stage shape.

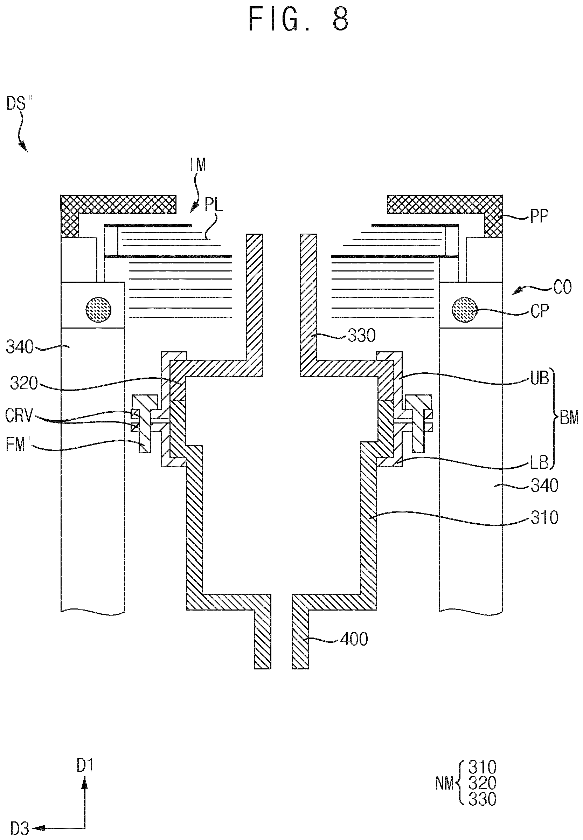

FIG. 8 is a schematic cross-sectional view illustrating a portion of a nozzle member of a deposition source according to an embodiment.

Referring to FIGS. 2 and 8, the nozzle member 300 of the deposition source DS" may include a nozzle module NM and a housing 340. For example, the nozzle module NM may include a crucible 310, a body 320, and nozzles 330. Hereinafter, redundant descriptions, which are similar to (or same as) the descriptions of the deposition source DS described with reference to FIGS. 6 and 7 will be omitted or simplified for descriptive convenience.

The deposition source DS" further includes a block member BM coupling the body 320 and the crucible 310 together. The block member BM may cover at least a portion of side surface of each of the body 320 and the crucible 310. For example, no hole may be formed in each of the body 320 and the crucible 310. Accordingly, a fastening member (such as the fastening member FM of FIGS. 3 and 4) is not used to couple the body 320 and the crucible 310 together.

The block member BM may include an upper block UB and a lower block LB. The upper block UB may contact at least a portion of a side surface of the body 320, and the lower block LB may contact at least a portion of a side surface of the crucible 310. Each of the upper block UB and the lower block LB may extend in the second direction D2. For example, the upper block UB and the lower block LB may have symmetrical shapes.

The deposition source DS" may further include an insulating member (e.g., heat insulating member) IM. The heat insulating member IM may be disposed to be adjacent to the nozzles 330. The heat insulating member IM may include plates PL. For example, the heat insulating member IM may have a multi-stage shape. The plates PL may be coupled to each other. For example, each of the plates PL may extend along a direction (e.g., the second direction D2) in which the nozzles 330 are spaced apart.

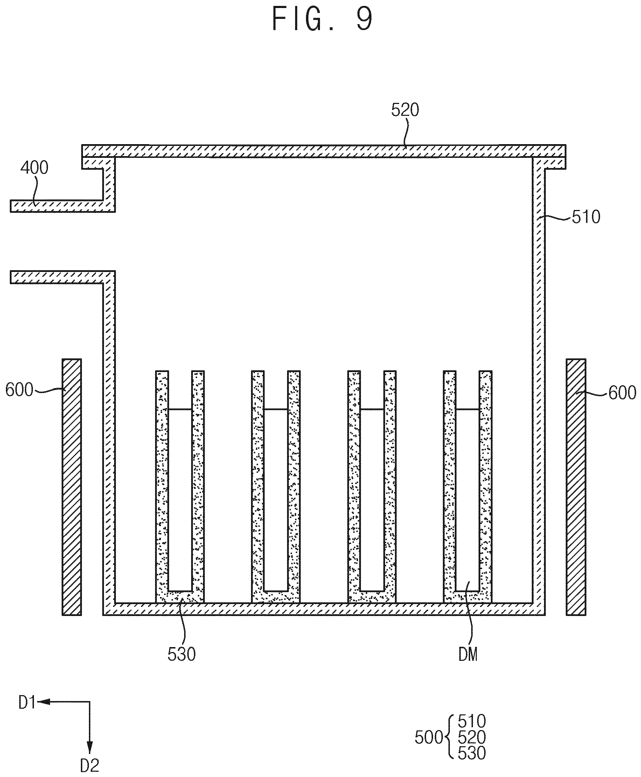

FIG. 9 is an enlarged schematic cross-sectional view of an example of a vaporizing member and a heating member of FIG. 1.

Referring to FIGS. 1 and 9, the deposition source DS may include the vaporizing member 500 and the heating member 600. For example, the vaporizing member 500 may include a body portion 510 and a cover portion 520.

The vaporizing member 500 may include a vaporizing module including the body portion 510 and the cover portion 520 and a housing accommodating the vaporizing module. For example, the housing may protect the vaporization module by accommodating the vaporization module therein.

The body portion 510 may store a deposition material DM. For example, a storage container 530 capable of storing the deposition material DM may be disposed inside the body portion 510. The storage container 530 may be arranged in plurality. For example, the storage container 530 may have a rectangular shape with a side open in cross section.

The cover portion 520 may be disposed on the body portion 510. The cover portion 520 may cover the upper surface of the body portion 510.

The vaporizing member 500 may include a heat-resistant material. For example, the vaporizing member 500 may include a heat-resistant material such as metal, alloy, ceramic, glass, carbon material, and the like. These may be used alone or in combination with each other. However, embodiments are not limited thereto, and the vaporizing member 500 may include various heat-resistant materials.

The heating member 600 may be disposed to be adjacent to the vaporizing member 500. The heating member 600 may heat the vaporizing member 500. For example, the heating member 600 may heat the vaporizing member 500 to heat the deposition material stored inside the vaporizing member 500. The heating member 600 may be disposed to be adjacent to a side surface (e.g., a side surface of the body portion 510) of the vaporizing member 500. For example, the heating member 600 may surround a side surface (e.g., a side surface of the body portion 510) of the vaporizing member 500. However, embodiments are not limited thereto, and the heating member 600 may be disposed around the vaporizing member 500 in various ways.

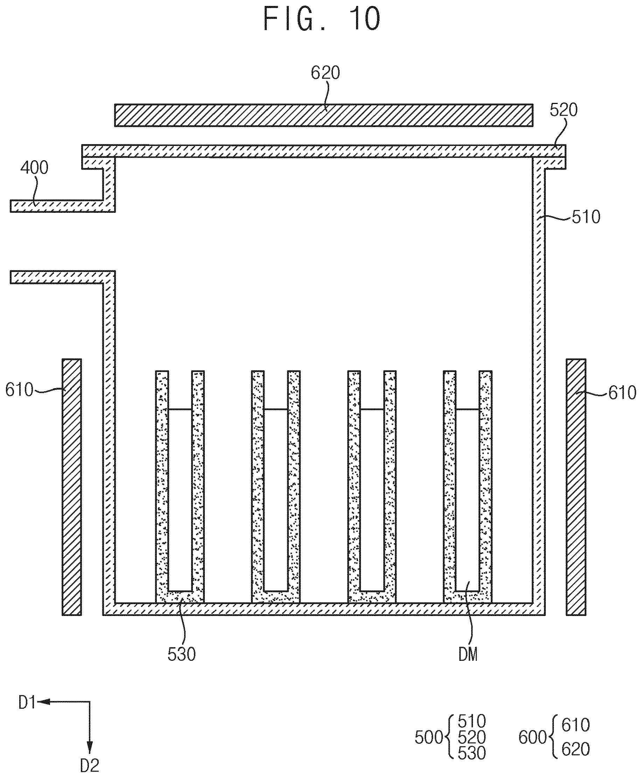

FIG. 10 is an enlarged schematic cross-sectional view of another example of a vaporizing member and a heating member of FIG. 1.

Referring to FIGS. 1 and 10, the deposition source DS may include the vaporizing member 500 and the heating member 600. For example, the vaporizing member 500 may include the body portion 510 and the cover portion 520. Hereinafter, redundant descriptions, which are similar to (or same as) the descriptions of the vaporizing member 500 and the heating member 600 described with reference to FIG. 9 will be omitted or simplified for descriptive convenience.

The body portion 510 may store the deposition material DM. For example, the storage container 530 for storing the deposition material DM may be disposed inside the body portion 510. For example, the storage container 530 may have a rectangular shape with a side open in cross section. The cover portion 520 may be disposed on the body portion 510. The cover portion 520 may cover the upper surface of the body portion 510.

The vaporizing member 500 may include a heat-resistant material. For example, the vaporizing member 500 may include a heat-resistant material such as metal, alloy, ceramic, glass, carbon material, and the like. These may be used alone or in combination with each other. However, embodiments are not limited thereto, and the vaporizing member 500 may include various heat-resistant materials.

The heating member 600 may be disposed to be adjacent to the vaporizing member 500. The heating member 600 may include a first heating member 610 disposed to be adjacent to a side surface of the vaporizing member 500 and a second heating member 620 disposed to be adjacent to an upper surface of the vaporizing member 500. For example, the first heating member 610 may be disposed to be adjacent to the side surface of the body portion 510 of the vaporizing member 500, and the second heating member 620 may be disposed to be adjacent to the upper surface of the cover portion 520 of the vaporizing member 500.

The disclosure may be applied to a process of manufacturing various display devices. For example, the disclosure may be applied to a process for manufacturing high-resolution smartphones, mobile phones, smart pads, smart watches, tablet PCs, vehicle navigation systems, televisions, computer monitors, laptops, and the like.

In concluding the detailed description, those skilled in the art will appreciate that many variations and modifications may be made to the embodiments while still falling within the scope of the invention as defined by the claims. Therefore, the disclosed embodiments are used in a generic and descriptive sense only and not for purposes of limitation.

## Claims

1. A deposition source (DS) comprising:
a nozzle member (300) including:
a body portion (320) including at least one first elongate hole (H1);
a plurality of nozzles (330) coupled to a first surface of the body portion to eject a deposition material; and
a crucible (310) including at least one second hole (H2) overlapping the first hole, the crucible being coupled to a second surface of the body portion by a fastening member (FM) inserted into the first hole and the second hole, the fastening member including a bolt and a nut, and optionally a washer;
a vaporizing member (500) spaced apart from the nozzle member and storing the deposition material; and
a connecting member (400) connecting the nozzle member (300) and the vaporizing member (500), and through which the deposition material moves, wherein
each of the plurality of nozzles extends in a first direction, and
the plurality of nozzles are spaced apart from each other along a second direction perpendicular to the first direction, wherein the width of the first hole (H1) in the second direction is greater than the width of the second hole (H2) in the second direction to allow the body portion and the crucible to move relative to one another.

2. The deposition source of claim 1, wherein
each of the plurality of nozzles is configured to spray the deposition material in the first direction, and
each of the body portion and the crucible extends in the second direction.

3. The deposition source of claim 1 or 2, further comprising:
a heat insulating member adjacent to the plurality of nozzles and coupled to a plurality of plates.

4. The deposition source of any one of the preceding claims, further comprising:
a heating member (600) adjacent to the vaporizing member to heat the vaporizing member.

5. The deposition source of claim 4, wherein the heating member (600) includes:
a first heating member (610) adjacent to a side surface of the vaporizing member; and
a second heating member (620) adjacent to an upper surface of the vaporizing member.

6. The deposition source of any one of the preceding claims, wherein the body portion and the plurality of nozzles are integral with each other, or wherein the body portion and the plurality of nozzles are formed independently of each other.

7. A deposition source (DS', DS") comprising:
a nozzle member (300) including:
a body portion (320),
a plurality of nozzles (330) coupled to a first surface of the body portion to eject a deposition material, and
a crucible (310) coupled to a second surface of the body portion;
a block member (BM) surrounding at least a portion of a side surface of each of the body portion and the crucible to couple the body portion and the crucible while allowing the body portion and the crucible to move relative to one another;
a vaporizing member (500) spaced apart from the nozzle member and storing the deposition material; and
a connecting member (400) connecting the nozzle member (300) and the vaporizing member (500), and through which the deposition material moves.

8. The deposition source of claim 7, wherein the block member includes:
an upper block (UB) contacting at least a portion of the side surface of the body portion; and
a lower block (LB) contacting at least a portion of the side surface of the crucible.

9. The deposition source of claim 8, wherein
each of the upper block and the lower block including a coupling groove penetrating each of the upper block and the lower block, and
the upper block and the lower block are coupled by a fastening member (FM') inserted into the coupling groove, optionally wherein the fastening member includes a bolt and a nut.

10. The deposition source of claim 8 or 9, wherein the upper block and the lower block have symmetrical shapes.

11. The deposition source of any one of claims 7 to 10, further comprising:
a heat insulating member (IM) adjacent to the plurality of nozzles.

12. The deposition source of claim 11, wherein the heat insulating member includes:
a first plate (PL1); and
a second plate (PL2) disposed on the first plate.

13. The deposition source of claim 11, wherein the heat insulating member includes a plurality of plates (PL) coupled to each other.

14. The deposition source of claim 3 or 13, wherein the plurality of plates are coupled by a first fastening member penetrating the plurality of plates and a second fastening member disposed between the plurality of plates and surrounding the first fastening member.

15. The deposition source of claim 14, wherein
the first fastening member has a pin shape, and
the second fastening member has a ring shape.
